# EUROPEAN PATENT SPECIFICATION

(11) **EP 1 795 706 B1**
(45) Date of publication and mention of the grant of the patent: **28.10.2009**
(21) Application number: 06125248.2
(22) Date of filing: 01.12.2006
(51) Int. Cl.: F01D 5/28

(54) **Platinum plated powder metallurgy turbine disk for elevated temperature service**
Platinierte pulvermetallurgische Turbinenscheibe für Hochtemperaturanwendungen
Disque de turbine de métallurgie des poudres plaqué platine pour une utilisation à température élevée

(30) Priority: 07.12.2005 US 297231
(43) Date of publication of application: 13.06.2007
(73) Proprietor: Honeywell International Inc., Morristown NJ 07960 (US)
(72) Inventor: Greving, Daniel J., Portland, AZ 97266 (US); Hieber, Andrew F., Scottsdale, AZ 85260 (US); Rice, Derek A., Phoenix, AZ 85044 (US)
(74) Representative: Haley, Stephen

(56) References cited:
- EP-A- 1 321 541
- EP-A- 1 507 022
- US-A- 3 494 748
- HAYNES, J.A. (OAK RIDGE NATIONAL LABORATORY) ET AL: "Characterization of commercial EB-PVD TBC systems with CVD (Ni,Pt)Al bond coatings." SURFACE AND COATINGS TECHNOLOGY , VOL. 146-147, PP. 140-146, NUMERICAL DATA, GRAPHS, PHOTOMICROGRAPHS, 19 REF. . SWITZERLAND CONFERENCE: 28TH INTERNATIONAL CONFERENCE ON METALLURGICAL COATINGS AND THIN FILMS, SAN DIEGO, USA, 30 APRIL - 4 MAY 2001, 2001, XP009081365
- DATABASE METADEX [Online] FISHER, G. (UNIVERSITY OF NORTHUMBRIA) ET AL: "Investigation of the oxidation resistance of platinum aluminide coatings produced by either high or low activity processes." XP009081381 retrieved from STN Database accession no. 2000(9):58-1347 & HIGH TEMPERATURE SURFACE ENGINEERING , PP. 1-11, PHOTOMICROGRAPHS, GRAPHS, 14 REF. PUBLISHED BY: INSTITUTE OF MATERIALS. 1 CARLTON HOUSE TERRACE, LONDON, SW1Y 5DB, UK CONFERENCE: SIXTH INTERNATIONAL CONFERENCE IN THE SERIES "ENGINEERING THE SURFACE", 2000,

## Description

The present invention relates generally components comprising to turbine disks for gas turbine engines, and more particularly to turbine disks having an oxidation barrier coating.

Gas turbine engines having hotter exhaust gases and which operate at higher temperatures are more efficient. To maximize the efficiency of gas turbine engines, attempts have been made to form gas turbine engine components, such as turbine disks, having higher operating temperature capabilities (e.g., above about 704°C (1300°F). In particular, there is considerable commercial interest in superalloy components for turbine disk applications which exhibit dwell fatigue and creep resistance at relatively high temperatures (e.g., exceeding about 704°C (1300°F).

Conventional alloy turbine disks are limited to an operating temperature of < 704°C (1300°F) (typically about 593°C (1100°F)). Such disks are typically made by inert gas atomization of the alloys into powder form. The powder may be subsequently screened to an appropriate size range and consolidated by hot compaction or by hot isostatic pressing (HIP). The consolidated powder may be then extruded into a form suitable for isothermal forging into a shape that can be machined into a turbine disk or other engine component. Components may also be formed by hot isostatic pressing (HIP) without the extrusion and isothermal forging steps, and subsequently machined to final shape. These methods of manufacture are common throughout the industry and well known in the art. However, providing a conventional turbine disk for sustained elevated temperature service is problematic because resistance to dwell fatigue and corrosion resistance properties for conventional alloy turbine disks tend to be poor at temperatures greater than about 704°C (1300°F).

As can be seen, there is a need for apparatus, compositions, and methods for providing components for gas turbine engines, such as turbine disks, capable of sustained operation at turbine disk rim temperatures in excess of 704°C (1300°F).

US-A-3494748 discloses a method performing a high temperature oxidation-resistance structural member by coating it with an alloy of platinum and at least one other element.

The present invention, relates to coated component, comprising:
a turbine disk, and
an oxidation barrier coating disposed on at least an outer portion of said turbine disk; wherein:
   said turbine disk comprises a superalloy, and
   said oxidation barrier coating comprises a binary platinum zirconium alloy the binary platinum alloy comprising one or more intermetallic phases selected from the group consisting of Pt3Zr and Pt11Zr9, wherein the binary platinum zirconium alloy comprising Pt3Zr includes about 86% platinum and about 14% zirconium, by weight, and the binary platinum zirconium alloy comprising Pt11Zr9 includes about 72% platinum and about 28% zirconium, by weight.

Preferably, the turbine disk comprises a nickel-based superalloy or a cobalt-based superalloy.

These and other features, aspects, and advantages of the present invention will become better understood with reference to the following drawings, description, and claims.

In the drawings:
Figure 1A is a perspective view of a high temperature turbine disk for a gas turbine engine, according to an aspect of the instant invention;
Figure 1B is a sectional view of an oxidation barrier coating disposed on a turbine disk surface, also according to the instant invention;
Figure 2 schematically represents a series of steps involved in a method for preparing an alloy turbine disk having an oxidation barrier coating, according to another embodiment of the invention;
Figure 3A is a plan view of a masked turbine disk, according to another aspect of the instant invention;
Figure 3B is a radial sectional view of the masked disk of Figure 3A;
Figure 4A is a scanning electron micrograph of a section of an oxidation barrier coating on a superalloy substrate, according to another aspect of the instant invention; and
Figure 4B is an energy dispersive X-ray spectrum of the oxidation barrier coating of Figure 4A.

The following detailed description is of the best currently contemplated modes of carrying out the invention. The description is not to be taken in a limiting sense, but is made merely for the purpose of illustrating the general principles of the invention.

The present invention relates to a coated component for gas turbine engine operation at sustained high temperatures (e.g., > 704°C (1300°F). It provides an alloy turbine disk having a ductile oxidation barrier coating (OBC) disposed on at least an outer portion thereof. The present invention may find applications in turbomachinery, including turbo fan, turbo shaft, and turbo prop engines. The present invention may be used for gas turbine engine of aircraft, as well as for industrial turbomachinery for power generation, and the like.

Alloy turbine disks of the present invention may include an oxidation barrier coating disposed an at least an outer portion of the turbine disk, wherein the oxidation barrier coating may comprise a layer of ductile metal, e.g., a Pt binary alloy with zirconium. The ductile oxidation barrier coating on the outer portion or rim of the turbine disk of the present invention may prevent surface oxide formation and intergranular attack, thereby delaying the onset of surface initiated low cycle fatigue (LCF) cracking, hence, the component life of the coated turbine disks of the present invention may be dramatically extended. In contrast to the present invention, turbine disks of the prior art lack a ductile oxidation barrier coating on the outer rim of the disk. Consequently, turbine disks of the prior art are readily susceptible to oxidation and corrosion, resulting in greatly decreased life of conventional components.

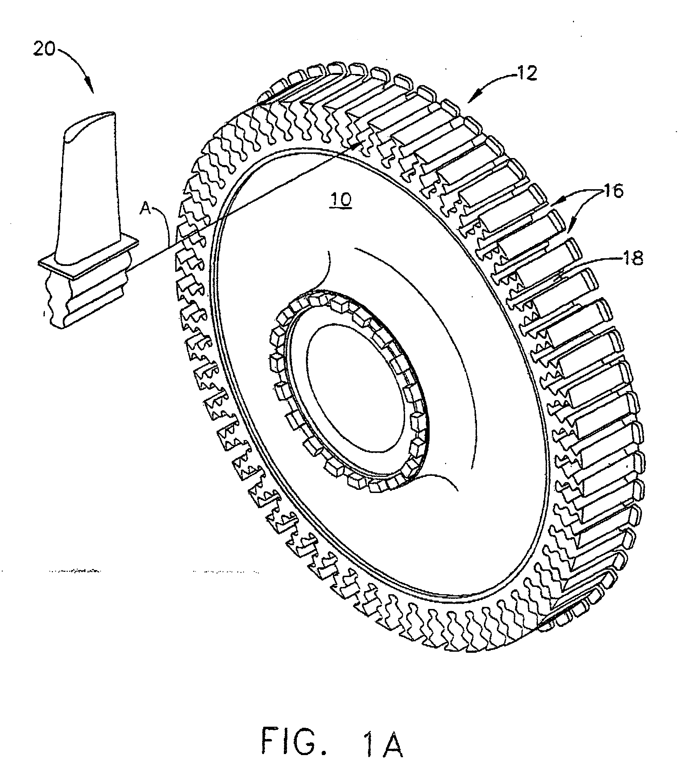

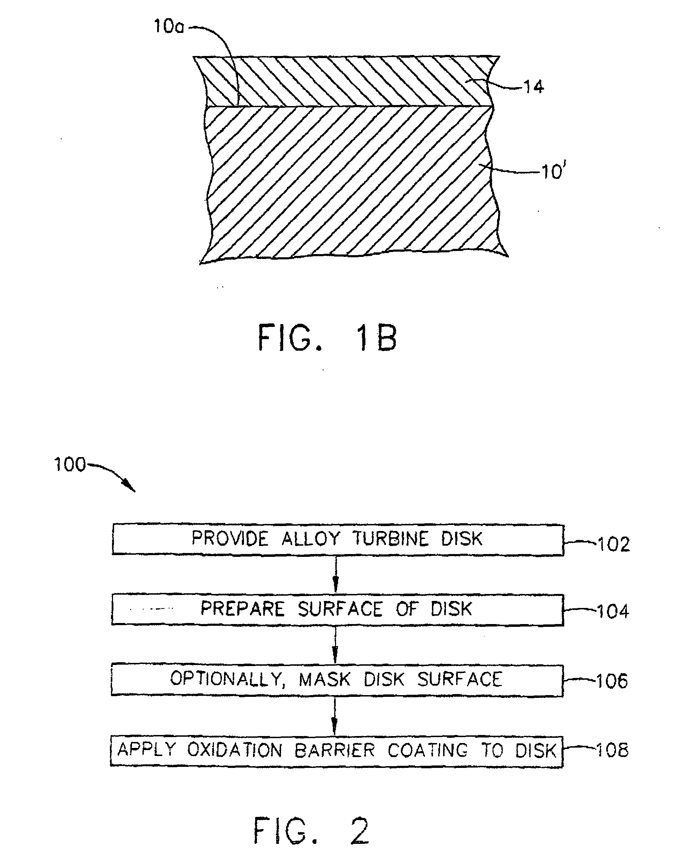

Figure 1A is a perspective view of a turbine disk 10 including an oxidation barrier coating (OBC) 14 (see, for example, Figure 1B), according to an embodiment of the instant invention. Turbine disk 10 may also be referred to by one of ordinary skill in the art as a rotor. Turbine disk 10 may include a disk outer portion 12. Outer portion 12 may also be referred to as an outer rim of turbine disk 10. Turbine disk 10 may further include a plurality of blade attachment slots 16, which may be disposed circumferentially on outer portion 12. Each blade attachment slat 16 may be configured for attachment of a turbine blade 20, as indicated by arrow A. Such attachment of turbine blades 20 to turbine disk 10 via blade attachment slots 16 is well known in the art. Turbine disk 10 may further include a blade attachment surface 18 located within each blade attachment slot 16. Turbine blade 20 may be a conventional turbine blade well known in the art. Turbine disk 10 may comprise a superalloy, which may be, for example, a nickel-based superalloy or a cobalt-based superalloy.

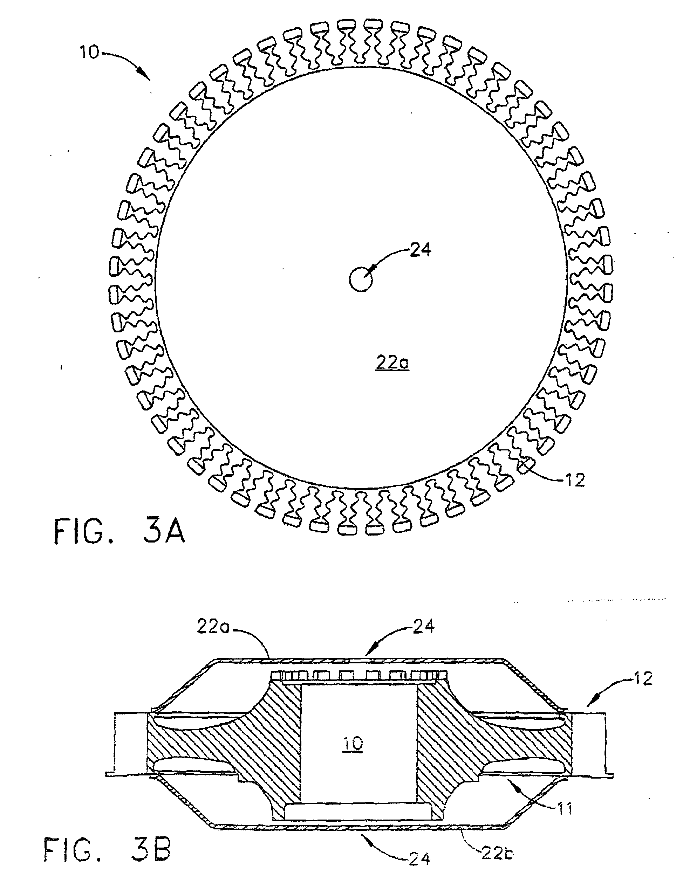

Figure 1B is a sectional view of a portion of turbine disk 10 showing oxidation barrier coating 14 disposed on disk surface 10a of turbine disk 10, also according to the instant invention. Oxidation barrier coating 14 may be selectively applied to disk outer portion 12 (see, for example, Figures 3A-B) such that an inner portion 11 (see, Figure 3B) of turbine disk 10 may lack oxidation barrier coating 14. Selective deposition of oxidation barrier coating 14 to disk outer portion 12 may decrease both the cost and weight of turbine disk 10. Disk surface 10a may comprise blade attachment surface 18 (see, Figure 1A). Naturally, disk outer portion 12 may not be limited to blade attachment surface 18. Oxidation barrier coating 14 may serve to prevent oxidation and corrosion of disk outer portion 12, including blade attachment slots 16. By preventing oxidation and corrosion of turbine disk 10, thereby delaying the onset of LCF cracking, the life of turbine disk 10 may be extended by more than two orders of magnitude as compared with conventional, uncoated alloy turbine disks of the prior art.

Oxidation barrier coating 14 may be a ductile coating. Oxidation barrier coating 14 may be resistant to prolonged exposure to temperature cycling at temperatures up to > 704°C. (1300°F) without cracking or spalling. Oxidation barrier coating 14 comprises a binary platinum alloy. Oxidation barrier coating 14 comprises Pt alloyed with zirconium (Zr). In various embodiments of the present invention, oxidation barrier coating 14 may comprise a Pt/Zr alloy comprising about 0-28 wt. % Zr, 72-100 wt. % Pt.

**Table 1. Wt. % Platinum (Pt) in OBC for Various Stable Phases**

| Phase | wt. % Pt |
|---|---|
| Pt₃Zr | ~86 |
| Pt₁₁Zr₉ | ~72 |

In the present invention, oxidation barber coating 14 comprises an intermetallic of Pt₃Zr or Pt₁₁Zr₉. Oxidation barrier coating 14 may comprise more than one of these phases within a binary platinum alloy. Exemplary values for wt. % platinum of oxidation barrier coating 14 predominantly comprising each of the above phases are shown in Table 1. Each composition presented in Table 1 is a stable phase, as shown by published phase diagrams (see, e.g., Binary Alloy Phase Diagrams, published by ASM International, 2002).

Oxidation barrier coating 14 may be applied to disk surface 10a using various deposition techniques well known in the art. As non-limiting examples; oxidation barrier coating 14 may be applied to disk surface 10a by physical vapor deposition (PVD), sputter coating, or electroplating.

Figure 2 schematically represents a series of steps involved in a method 100 for preparing a coated component, wherein the component may comprise an alloy, and the component may have an oxidation barrier coating disposed thereon, according to another embodiment of the invention. The component may comprise a turbine disk for a gas turbine engine.

Step 102 of method 100 may involve providing an alloy turbine disk. The turbine disk may be provided according to manufacturing techniques well known in the art, for example, powder metallurgy processes involving hot isostatic pressing (HIP), extrusion, and isothermal forging. Typically, turbine disk 10 may comprise a superalloy, such as a nickel-based superalloy or a cobalt-based superalloy. Such alloys are well known in the art.

Step 104 may involve preparing a surface of the turbine disk. The disk surface may be treated during step 104 such that all surface areas are water-break-free. Shop soils may be removed using a suitable aqueous degreaser or by vapor degreasing. In addition, surface oxides may be removed from the disk surface using a suitable acid etch. Such surface preparation techniques are well known in the art. Once the disk surface has been prepared, the turbine disk may be handled using lint-free cotton gloves.

Step 108 may involve applying the oxidation barrier coating to at least the outer portion of the turbine disk. During step 108, the entire outer portion of the turbine disk, including the blade attachment surface of each blade attachment slot, may be coated with the oxidation barrier coating. The oxidation barrier coating may be applied to the surface of the turbine disk using various deposition techniques, such as physical vapor deposition (PVD), sputter coating, or electroplating. Such deposition techniques are well known in the art. The oxidation barrier coating may be applied to the surface of the turbine disk as a single layer or as a plurality of layers.

As a result of masking the turbine disk in step 106 (*infra*), an inner portion of the turbine disk may remain uncoated after step 108 has been performed. That is to say, the oxidation barrier coating may be selectively applied to the outer portion of the turbine disk such that an inner portion of the turbine disk may lack the oxidation barrier coating.

The oxidation barrier coating applied in step 108 may have a thickness typically in the range of from about 800 nm to about 50 microns (0.002 inches), usually from about 800 nm to about 10 microns (µm), and often from about 1 micron to about 3 microns (µm). The oxidation barrier coating applied in step 108 may be a ductile coating which resists cracking and spalling following prolonged exposure to high temperatures (e.g., in excess of 704°C or 1300 deg. F) and repeated temperature cycling.

The oxidation barrier coating applied in step 108 comprises platinum, typically comprising at least about 97 wt. % platinum. Optional, step 106 may involve masking the turbine disk such that only an outer portion of the disk is exposed during deposition of the oxidation barrier coating (see, e.g., step 108, *infra*). As a non-limiting example, the turbine disk may be masked using a pair of metal plates disposed over an inner portion of each side of the turbine disk (see, for example, Figures 3A-B). following masking in step 106, the entire outer portion or outer rim of the turbine disk, including the blade attachment surface of each blade attachment slot (see, Figure 1A) may be exposed for deposition of the oxidation barrier coating thereon. To preclude entrapment of acid, e.g., between the disk surface and masking material, step 106 may be performed after step 104.

Figure 3A is a plan view of a masked turbine disk 10, and Figure 3B is a radial sectional view of the masked turbine disk 10 of Figure 3A, according to an aspect of the instant invention. A disk inner portion 11 of turbine disk 10 may be masked preparatory to deposition of the oxidation barrier coating, for example, as described hereinabove with reference to method 100 (Figure 2).

With reference to Figures 3A and Figure 3B, turbine disk 10 may be masked by a first plate 22a and a second plate 22b disposed over disk inner portion 11. First plate 22a and second plate 22b may each comprise, as an example, a formed metal plate, e.g., comprising Ni/steel, or the like, and having a bore 24 therethrough. First plate 22a and second plate 22b may be damped in place, e.g., via a bolt (not shown) extending through bore 24 of first plate 22a and second plate 22b. When first plate 22a and second plate 22b are clamped against turbine disk 10, the entire disk outer portion 12 may be exposed for deposition thereon of oxidation barrier coating 14 (see, Figure 1B).

### Comparative Example 1

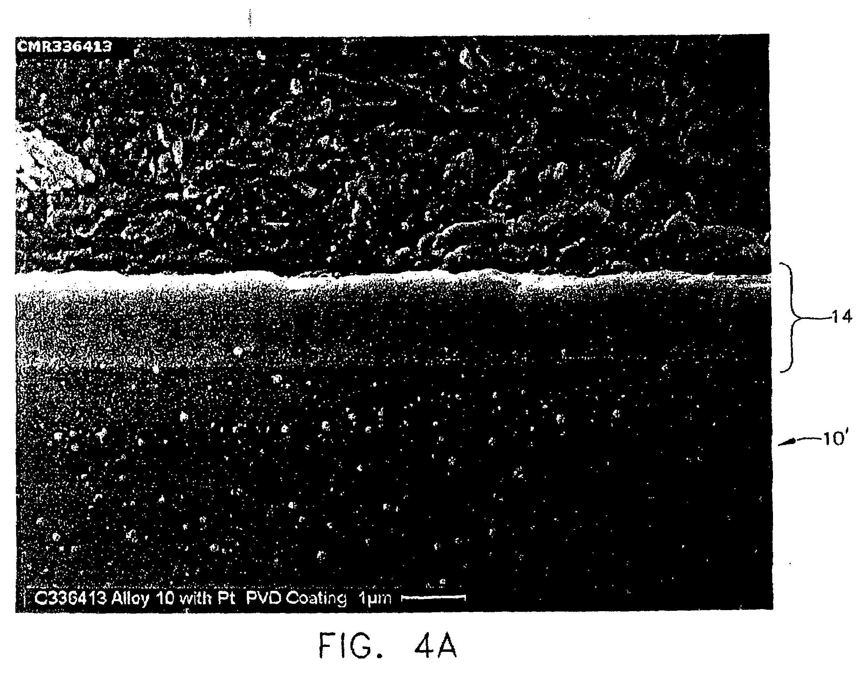

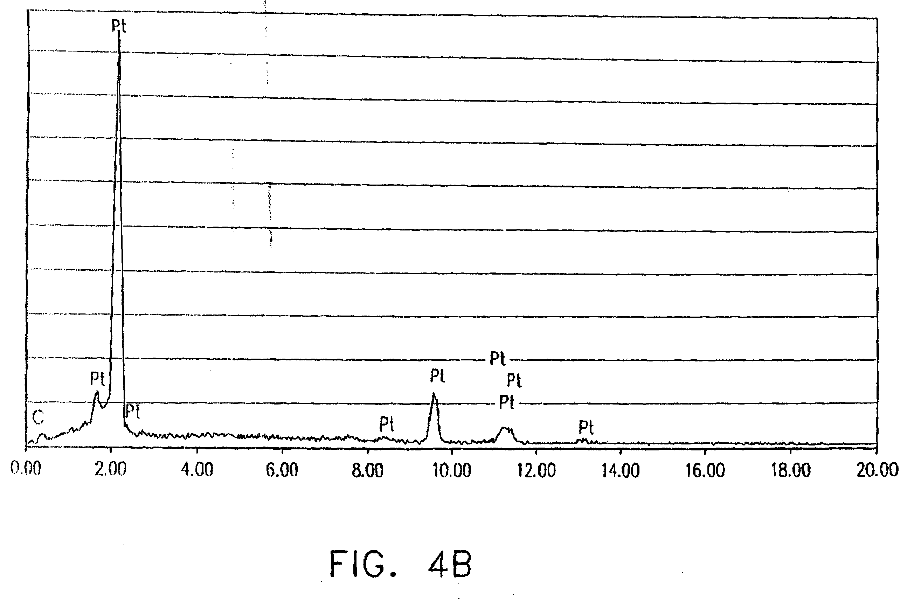

Figure 4A is a scanning electron micrograph of a section through an oxidation barrier coating 14 disposed as a substantially uniform layer on the surface of a substrate 10', wherein substrate 10' comprises Alloy 10 (nickel-based superalloy), according to another aspect of the instant invention. The surface of substrate 10' was degreased and acid etched to remove surface oxides prior to deposition of oxidation barrier coating 14 by physical vapor deposition (PVD). The bar shown in Figure 4A represents 1 µm. Figure 4B shows the results of energy dispersive X-ray (EDX) spectrometry of the oxidation barrier coating 14 of Figure 4A. The EDX spectrum shown in Figure 4B indicates that the oxidation barrier coating 14 of Figure 4A consists of substantially pure platinum (Pt).

Although the invention has been described primarily with respect to turbine disks, the present invention may also find applications for other components of gas turbine engines, and the like.

## Claims

1. A coated component, comprising:
a turbine disk (10); and
an oxidation barrier coating (14) disposed on at least an outer portion of said turbine disk (10);
wherein:
said turbine disk (10) comprises a superalloy, and
said oxidation barrier coating (14) comprises a binary platinum zirconium alloy, the binary platinum alloy comprising one or more intermetallic phases selected from the group consisting of Pt3Zr and Pt11Zr9, consisting of about 86% platinum and about 14% zirconium and about 72% platinum and about 28% zirconium, by weight.

2. The coated component according to claim1, wherein:
said oxidation barrier coating (14) is disposed on said outer portion (12) of said turbine disk (10), and
an inner portion of said turbine disk is uncoated by said oxidation barrier coating.

3. The coated component according to claims 1 or 2, wherein:
said outer portion (12) comprises a plurality of blade attachment slots (16),
each said blade attachment slot comprises a blade attachment surface (18), and
said oxidation barrier coating (14) is disposed on said blade attachment surface.

## Patentansprüche

1. Beschichtetes Bauteil umfassend:
eine Turbinenscheibe (10) und
eine Oxidationsbarrierebeschichtung (14), die sich auf mindestens einem äußeren Abschnitt der Turbinenscheibe (10) befindet,
wobei
die Turbinenscheibe (10) eine Superlegierung umfasst und
die Oxidationsbarrierebeschichtung (14) eine binäre Platin-Zirconium-Legierung umfasst, wobei die binäre Platin-Zirconium-Legierung eine oder mehrere Zwischenmetallphasen umfasst, die aus der Gruppe bestehend aus Pt3Zr und Pt11Zr9 bestehend aus etwa 86 Gew.-% Platin und etwa 14 Gew.-% Zirconium und etwa 72 Gew.-% Platin und etwa 28 Gew.-% Zirconium ausgewählt sind.

2. Beschichtetes Bauteil nach Anspruch 1, wobei:
die sich Oxidationsbarrierebeschichtung (14) auf dem äußeren Abschnitt (12) der Turbinenscheibe (10) befindet und
ein innerer Abschnitt der Turbinenscheibe nicht mit der Oxidationsbarrierebeschichtung (14) beschichtet ist.

3. Beschichtetes Bauteil nach Anspruch 1 oder 2,
wobei:
der äußere Abschnitt (12) mehrere Schaufelbefestigungsschlitze (16) umfasst,
jeder Schaufelbefestigungsschlitz eine Schaufelbefestigungsfläche (18) umfasst und
sich die Oxidationsbarrierebeschichtung (14) auf der Schaufelbefestigungsfläche befindet.

## Revendications

1. Composant revêtu comprenant :
un disque (10) de turbine et
un revêtement (14) de barrière à l'oxydation placé sur au moins une partie externe dudit disque (10) de turbine,
dans lequel :
ledit disque de turbine (10) est constitué d'un superalliage et
ledit revêtement (14) de barrière à l'oxydation est constitué d'un alliage binaire de platine et de zirconium, l'alliage binaire de platine étant constitué d'au moins une phase intermétallique sélectionnée dans l'ensemble constitué du Pt3Zr et du Pt11Zr9, d'environ 86 % de platine et d'environ 14 % de zirconium ou d'environ 72 % de platine et d'environ 28 % de zirconium, chaque fois en poids.

2. Composant revêtu selon la revendication 1, dans lequel :
ledit revêtement (14) de barrière à l'oxydation est placé sur ladite partie externe (12) dudit disque (10) de turbine et
une partie interne dudit disque de turbine n'est pas recouverte par ledit revêtement de barrière à l'oxydation.

3. Composant revêtu selon la revendication 1 ou 2, dans lequel :
ladite partie externe (12) comprend plusieurs encoches (16) de fixation de pales,
chacune desdites fentes de fixation de pales comprend une surface (18) de fixation de pales et
ledit revêtement (14) de barrière à l'oxydation est placé sur ladite surface de fixation de pales.
